# EUROPEAN PATENT APPLICATION

(11) **EP 1 202 339 A2**
(43) Date of publication of application: **02.05.2002**
(21) Application number: 01309005.5
(22) Date of filing: 24.10.2001
(51) Int. Cl.: H01L 21/762

(54) **Semiconductor substrate, method of manufacturing the same, and bonded substrate stack surface shape measuring method**

(30) Priority: 25.10.2000 JP 2000325802
(71) Applicant: CANON KABUSHIKI KAISHA, Tokyo (JP)
(72) Inventor: Sakaguchi, Kiyofumi, Ohta-Ku, Tokyo (JP)
(74) Representative: Beresford, Keith Denis Lewis

(57) **Abstract**

A semiconductor substrate having a managed surface shape is manufactured. In a method of manufacturing a semiconductor substrate by bonding a device substrate (1) to a handle substrate (5), the surface shape of the handle substrate on the bonding side is nearly equal to that of the resultant semiconductor substrate. In a surface shape measuring method for a bonded substrate stack manufactured by bonding a first substrate and a second substrate via an insulating layer, a pseudo bonded substrate stack is manufactured by bonding the first and second substrates without sandwiching any insulating layer, the surface shape of the pseudo bonded substrate stack is measured, and the measurement value is regarded as the surface shape of the bonded substrate stack.

## Description

### FIELD OF THE INVENTION

The present invention relates to a semiconductor substrate and method of manufacturing the semiconductor substrate using a bonding technique, and a bonded substrate stack surface shape measuring method.

### BACKGROUND OF THE INVENTION

As prior arts that disclose the relationship between the wafer surface properties and voids or techniques associated with the surface shape of a bonded substrate stack, Japanese Patent Laid-Open No. 62-283655 (NTT), Japanese Patent Laid-Open No. 5-152549 (Shin-Etsu Semiconductor, Nagano Denshi), Japanese Patent Publication No. 6-36407 (Shin-Etsu Semiconductor, Nagano Denshi), Japanese Patent Laid-Open No. 7-249598 (Mitsubishi Materials, Mitsubishi Materials Silicon), Japanese Patent Laid-Open No. 9-232197 (Sumitomo Sitix), and the like are known.

A reference, Takao Abe and John H. Matlock, "Solid State Technology/Japanese version", January 1991 (Shin-Etsu Semiconductor), also describes the correlation between the surface properties and voids.

If the properties of a semiconductor surface are poor, voids are formed.

Surface planarization has been promoted to meet the requirements of lithography.

The latest agenda on planarity is height difference in a several ten mm square, which is called site flatness. This is because, to form a very thin line pattern, any height difference on a wafer surface in one shot by a stepper (exposure apparatus) is required to be suppressed.

Evaluation items for planarity include, e.g., the upper limit of height difference, area size (the number of sites changes depending on the area size), and the site ratio (usable area) under the upper limit of height difference.

In the field of Si bulk wafer, that nanotopography or a surface shape between a surface shape discussed as surface microroughness and a surface shape discussed as surface planarity is very important is beginning to be recognized.

Dr. K.V. Ravi first used the word "nanotopology" (nanometer scale surface topology). Recently, "nanotopology" is called "nanotopography". In this application, "nanotopography" is used.

While the site flatness is regarded as a problem from the viewpoint of lithography, the nanotopography has been regarded as a problem from the viewpoint of CMP. In planarizing a dielectric interlayer by CMP, if the original surface is uneven, and this surface is planarized by CMP, the uniformity of thickness of the insulating film is lost, resulting in breakdown. In addition, in filling an STI (Shallow Trench Isolation) with an insulating film and then polishing the surface, not only the polishing uniformity of CMP itself but also the nanotopography of the original wafer must be indispensably improved. The problem of nanotopography has arisen for the first time when the line width of lithography has become as small as about 0.18 µm.

Nanotopography is measured by WIS-CR83-SQM or NanoMapper available from ADE, Surfscan-SP1-STN available from KLA-Tencor, DynaSearch available from New Creation, or NanoMetro available from KURODA PRECISION INDUSTRIES. All these measuring apparatuses optically measure a three-dimensional pattern using surface reflection.

The standards of site flatness and nanotopography need to be stricter as the device size decreases. Especially, it is obvious that next-generation materials such as SOI and SiGe will be used for leading-edge-technology lithography lines from the beginning.

The bonding techniques that are maturing recently have received a great deal of attention particularly as techniques for forming an SOI, and wafers for such techniques are commercially available. However, they are still scarecely employed for the leading-edge-technology 0.18-µm line. The site flatness of SOI is beginning to be on the agenda only recently, and nanotopography has received little attention. However, the site flatness or nanotopography of a wafer will definitely be an issue even in the applicable field of SOI or SiGe.

A substrate by a bonding technique is generally manufactured by the following processes.
a) A handle substrate and device substrate are prepared. A device substrate means a substrate containing a layer (i.e., active layer) on which a device will be finally formed.
b) The two wafers are bonded.
c) A region unused on the device substrate side (i.e., a region except the active layer) is removed.
d) The surface is smoothened.

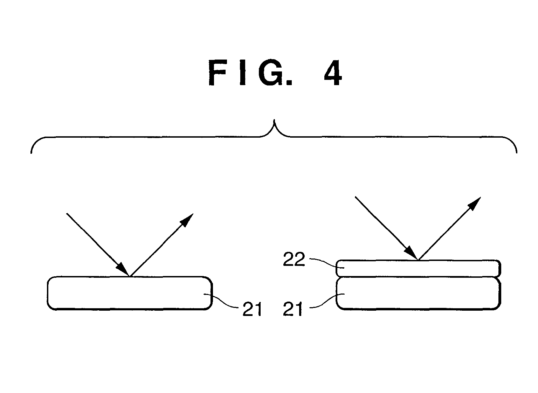

A surface shape measuring method is normally applied to measure a bulk wafer and therefore is not appropriate for measurement of a wafer having a multi-layered structure. Currently, only the surface shape of an epitaxial wafer is measured. When the impurity concentration changes in a single base material, most of the light that becomes incident on an epitaxial wafer is reflected by the surface, as is known (Fig. 4).

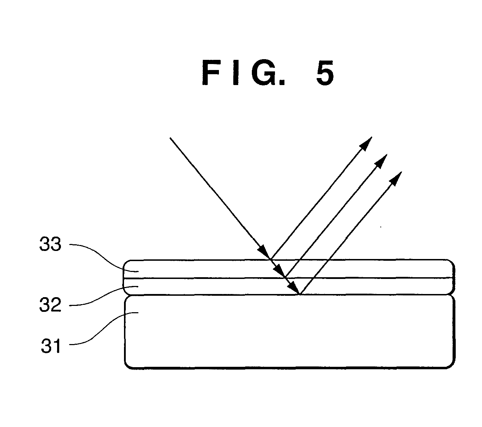

If the difference in optical constant such as refractive index between the multiple layers on the surface is large, the nanotopography of the wafer itself can hardly be measured. This is because the current nanotopography measuring method is an optical method. As shown in Fig. 5, an SOI structure contains Si, SiO₂, and Si sequentially from the surface. That is, the number of light reflecting surfaces is three, including the uppermost surface. For this reason, which surface has the nanotopography represented by the nanotopography measurement value is unknown.

### SUMMARY OF THE INVENTION

According to the present invention, there is provided a method of manufacturing a semiconductor substrate by bonding a device substrate to a handle substrate, characterized in that a surface shape of the handle substrate on a bonding side is almost equal to that of a resultant semiconductor substrate.

According to the present invention, there is also provided a method of manufacturing a semiconductor substrate by bonding a device substrate to a handle substrate, characterized in that a surface shape on a bonding-side surface of the handle substrate is represented by SFQR; 0.30 µm/25 mm × 25 mm/85% or more (i.e., in a set of 25 mm × 25 mm sites, the ratio of sites having a flatness of 0.30 µm or less is 85% or more) and a surface shape of the semiconductor substrate manufactured using the handle substrate satisfies SFQR; 0.30 µm/25 mm × 25 mm/85% or more.

The surface shape can be defined by various methods depending on how to define a reference plane and whether deviation or range is employed. In the present invention, the surface shape is preferably defined by at least one of an SFQR, SFQD, SBIR, and nanotopography.
(1) FQA (Flatness Quality Area)
(2) SFPD (Site Focal Plane Deviation)
(3) STIR (Site Total Indicator Reading)
(4) SBID (Site Back Ideal Deviation)
(5) SBIR (Site Back Ideal Range) = LTV (Local Thickness Variation)
(6) SFPD (Site Front Plane Deviation)
(7) SFLD (Site Front Least-squares Deviation)
(8) SFLR (Site Front Least-squares Range)
(9) SFQD (Site Front least-sQuares site Deviation)
(10) SFQR (Site Front least-sQuares site Range)
(11) SF3D (Site Front Three point Deviation)
(12) SF3R (Site Front Three point Range)

When an in-site plane obtained by calculating data in a set site by the least square method is defined as a reference plane, and a plane parallel to

the reference plane and including a site central point is defined as a focal plane, an SFQR is represented by the sum of absolute values of + and - maximum displacement amounts from the focal plane in each site. Each site has one SFQR data. When the lower surface of a wafer is defined as a reference plane, and a plane including a site central point in each site is defined as a focal plane, an SBIR is represented by the sum of absolute values of + and - maximum displacement amounts from the plane. Each site has one SBIR data. A nanotopography means the deviation of a surface in a spatial wavelength range of about 0.2 to 20 nm.

According to the present invention, there is also provided a method of manufacturing a semiconductor substrate by bonding a device substrate to a handle substrate, characterized in that a surface shape of the handle substrate on a bonding side satisfies at least one of conditions:
a maximum p-v (peak to valley) value in all 0.5 mm × 0.5 mm cells is not more than 20 nm,
the maximum p-v value in all 2.0 mm × 2.0 mm cells is not more than 50 nm,
the maximum p-v value in all 5.0 mm × 5.0 mm cells is not more than 100 nm, and
the maximum p-v value in all 10 mm × 10 mm cells is not more than 120 nm, and
a surface shape of the semiconductor substrate manufactured using the handle substrate satisfies the same conditions satisfied by the handle substrate in conditions:
the maximum p-v (peak to valley) value in all 0.5 mm × 0.5 mm cells is not more than 20 nm,
the maximum p-v value in all 2.0 mm × 2.0 mm cells is not more than 50 nm,
the maximum p-v value in all 5.0 mm × 5.0 mm cells is not more than 100 nm, and
the maximum p-v value in all 10 mm × 10 mm cells is not more than 120 nm.

According to the present invention, there is also provided a method of manufacturing a semiconductor substrate by bonding a device substrate to a handle substrate, characterized in that a surface shape of the handle substrate satisfies at least one of conditions:
a maximum p-v (peak to valley) value in all 0.5 mm × 0.5 mm cells is not more than 20 nm,
the maximum p-v value in all 2.0 mm × 2.0 mm cells is not more than 50 nm,
the maximum p-v value in all 5.0 mm × 5.0 mm cells is not more than 100 nm, and
the maximum p-v value in all 10 mm × 10 mm cells is not more than 120 nm.

According to the present invention, there is also provided a surface shape measuring method for a bonded substrate stack manufactured by bonding a first substrate and a second substrate via a layer formed from a heterogeneous material different from the first substrate or second substrate, characterized in that a pseudo bonded substrate stack is manufactured by bonding a first substrate and a second substrate without sandwiching the layer of the heterogeneous material, a surface shape of the pseudo bonded substrate stack is measured, and a measurement value is regarded as a surface shape of the bonded substrate stack.

Other features and advantages of the present invention will be apparent from the following description taken in conjunction with the accompanying drawings, in which like reference characters designate the same or similar parts throughout the figures thereof.

### BRIEF DESCRIPTION OF THE DRAWINGS

The accompanying drawings, which are incorporated in and constitute a part of the specification, illustrate embodiments of the invention and, together with the description, serve to explain the principles of the invention.
Figs. 1A to 1F are sectional views showing a semiconductor substrate manufacturing method according to the first embodiment of the present invention;
Figs. 2A to 2F are sectional views showing a semiconductor substrate manufacturing method according to the second embodiment of the present invention;
Fig. 3 is an explanatory view showing a bonded substrate stack surface shape measuring method according to the present invention;
Fig. 4 is a view for explaining the surface shape measuring method;
Fig. 5 is a view for explaining the surface shape measuring method;
Figs. 6A and 6B are schematic sectional views for explaining examples in which the site flatness or nanotopography is satisfactory; and
Figs. 7A and 7B are schematic sectional views for explaining examples in which the site flatness or nanotopography is not satisfactory.

### DETAILED DESCRIPTION OF THE PREFERRED EMBODIMENTS

A semiconductor substrate manufacturing method according to a preferred embodiment of the present invention will be described first.

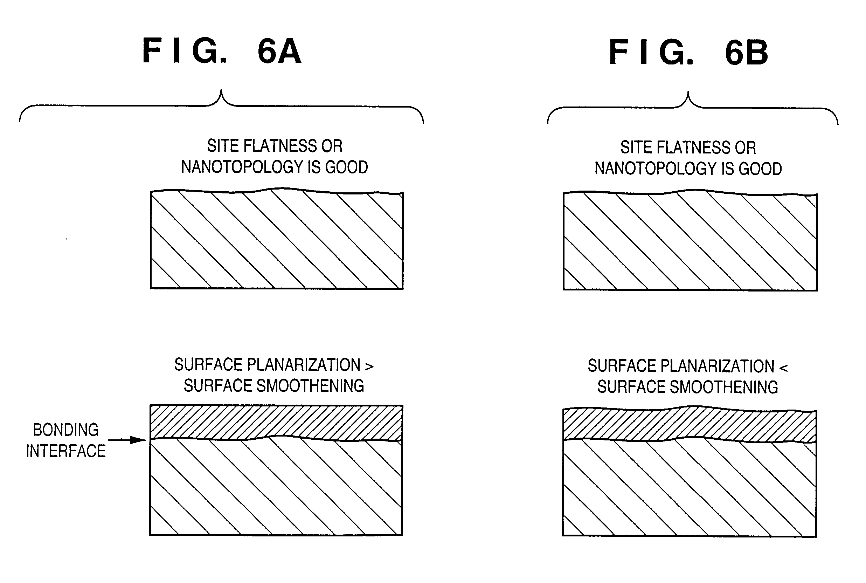

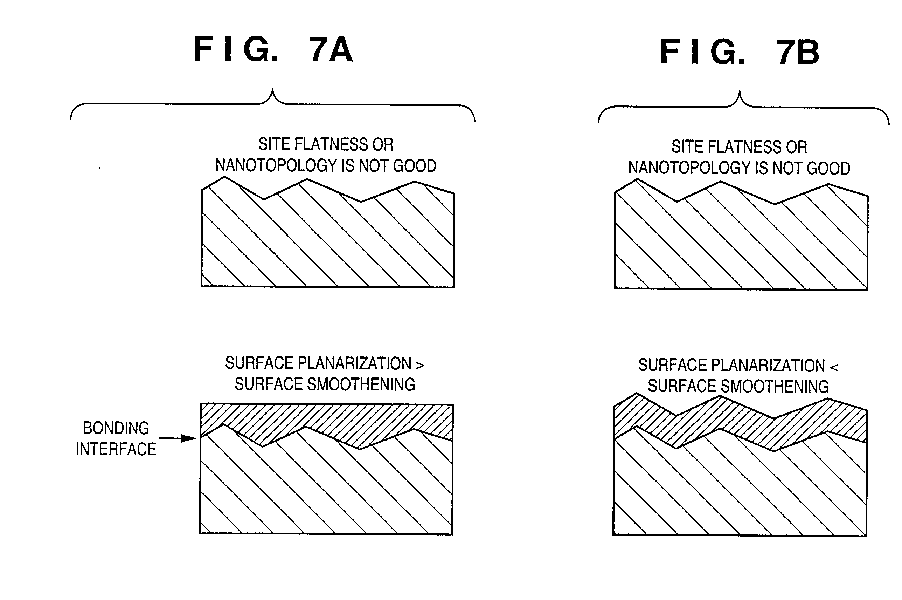

As shown in Figs. 6A, 6B, 7A, and 7B, factors that determine the site flatness and nanotopography of a semiconductor substrate formed by a bonding technique are the site flatness and nanotopography of the original handle substrate and the surface planarization and smoothening techniques. Figs. 6A and 6B are schematic sectional views for explaining cases in which the site flatness or nanotopography is satisfactory. Figs. 7A and 7B are schematic sectional views for explaining cases in which the site flatness or nanotopography is not satisfactory. Referring to Figs. 6A, 6B, 7A, and 7B, the upper substrate is the second substrate serving as a handle substrate, and the lower substrate is the second substrate having a layer (only an active layer or multiple layers including an active layer) transferred from the first substrate serving as a device substrate by the bonding technique.

Fig. 6A shows a technique (ideal CMP for flattening a surface) in which the surface of the handle substrate after transfer is perfectly planarized by using a handle substrate having satisfactory site flatness or nanotopography.

Fig. 6B shows a technique (ideal smoothening technique without any decrease in film thickness) in which an ideal uniform film is left on the handle substrate after transfer by using a handle substrate having satisfactory site flatness or nanotopography.

Fig. 7A shows a technique (ideal CMP for flattening a surface) in which the surface of the handle substrate after transfer is perfectly planarized by using a handle substrate having poor site flatness or nanotopography.

Fig. 7B shows a technique (ideal smoothening technique without any decrease in film thickness) in which an ideal uniform film is left on the handle substrate after transfer by using a handle substrate having poor site flatness or nanotopography.

If it is only required to obtain satisfactory site flatness or nanotopography on the final substrate, only surface planarization in the final process is important. However, if the nanotopography of the original handle substrate is poor, film thickness unevenness occurs in the active layer (Fig. 7A).

Referring to Figs. 6A, 6B, 7A, and 7B, "surface smoothening" means a process of smoothening the surface layer of the final substrate without any decrease in film thickness while keeping the surface shape (the surface shape of an underlying layer) immediately before unchanged, and "surface planarization" means a process of flattening the surface shape independently of the surface shape (the surface shape of an underlying layer) immediately before. Figs. 6A, 6B, 7A, and 7B show cases wherein one of the surface smoothening and surface planarization is dominant. If CMP or polishing is executed, an in-plane polishing distribution is also present.

With ideal smoothening, the nanotopography almost keeps the original state (the surface shape of the underlying layer) and also maintains film thickness uniformity (Figs. 6A and 7B). That is, if ideal smoothening is possible, the site flatness or nanotopography need not be taken into consideration in ensuring film thickness uniformity. However, the site flatness or nanotopography of the original handle substrate is reflected on the surface of the final substrate.

With ideal planarization, the site flatness or nanotopography is determined by the planarization process independently of the original state (the surface shape of the underlying layer). However, along with the improvement in planarity, the film thickness uniformity degrades (Figs. 6A and 7A). This degradation is especially conspicuous when the site flatness or nanotopography of the original handle substrate is poor (Fig. 7A).

If the original site flatness or nanotopography is poor (Figs. 7A and 7B), both film thickness uniformity and good site flatness or nanotopography cannot be simultaneously obtained even by the planarization/smoothening process. Hence, to obtain satisfactory site flatness or nanotopography while maintaining film thickness uniformity of the surface active layer in manufacturing a semiconductor substrate by bonding, the site flatness or nanotopography or the original handle substrate is improved.

A handle substrate having good surface properties also acts to suppress void formation upon bonding. When the surface roughness of a handle substrate is also limited, wafers having satisfactory site flatness or nanotopography can be manufactured at a higher bonding yield.

When the site flatness or nanotopography of a handle substrate is improved by smoothening, the site flatness or nanotopography of a semiconductor substrate formed by bonding remains high, and variations between wafers, between lots, or between processes when a process is changed are minimized. Especially, as smoothening, annealing (hydrogen annealing) is more effective rather than CMP. CMP smoothens/planarizes a surface while grinding projecting portions on the surface, though annealing in hydrogen-containing atmosphere only smoothens a surface with little decrease in film. For this reason, CMP changes the surface shape to some extent while hydrogen annealing does not change the surface shape at all.

To improve the site flatness or nanotopography of a handle substrate, it is important to use a second substrate having a managed surface shape (to use wafers without any variation between them after all). When the surface shape of the original second substrate is managed, a semiconductor substrate having a managed surface shape can be manufactured.

A surface shape measuring method, according to a preferred embodiment of the present invention, for a semiconductor substrate formed by the bonding technique, will be described next.

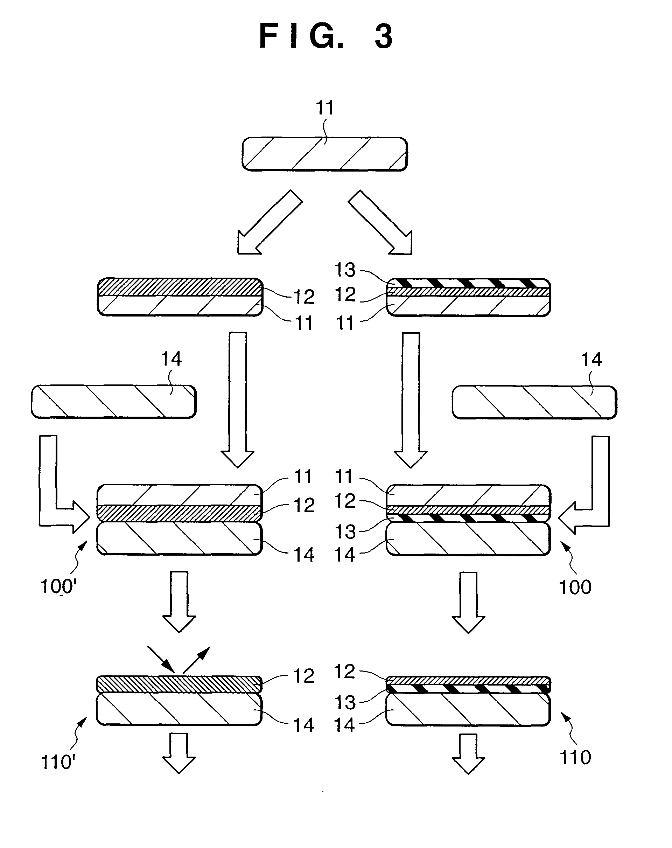

In the preferred embodiment of the present invention, a shown in Fig. 3, the nanotopography of a semiconductor substrate 110' which is manufactured by bonding a first substrate 11 with an active layer 12 as a non-porous layer to a second substrate 14 without intervening an oxide film 13 to form an intermediate body 100' and then removing the first substrate 11 from the intermediate body 100' (a method shown on the left side of Fig. 3) is defined as the nanotopography of a semiconductor substrate 110 which is obtained by bonding the first substrate 11 with the active layer 12 as a non-porous layer to the second substrate 14 via the oxide film 13 serving as an insulating layer to form an intermediate body 100 and then removing the first substrate 11 from the intermediate body 100 (a method shown on the right side of Fig. 3). This makes it possible to quantitatively express, as a numerical value, the surface nanotopography of a semiconductor substrate (particularly an SOI substrate) formed by bonding, which is conventionally difficult to express as a numerical value.

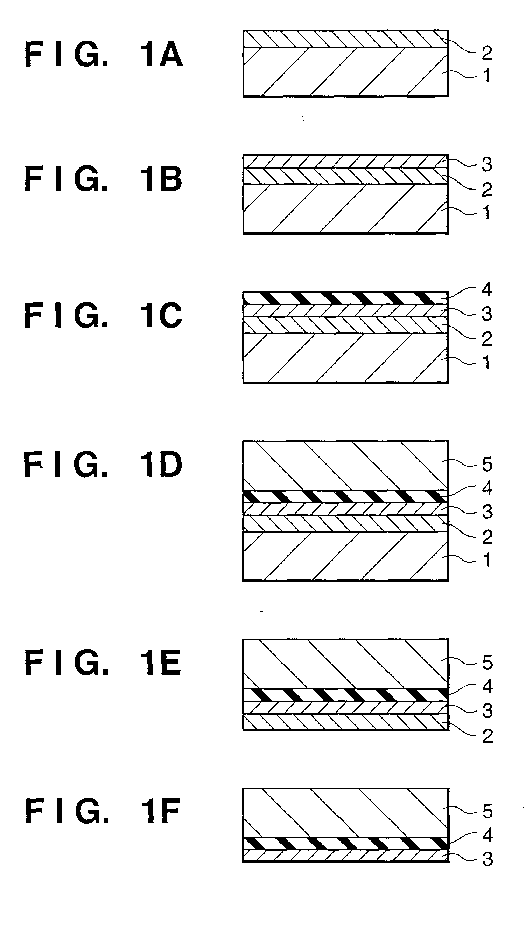

When the reproducibility of each process is high, the measurement by this measuring method is sufficiently meaningful. The latest techniques for manufacturing a bonded semiconductor substrate stack have accomplished marked growth, and the above method can be effectively applied. Referring to Fig. 3, reference numeral 11 denotes a first substrate formed from a porous layer (the first substrate is wholly made of a porous layer here, though a porous layer may be formed at part of the surface); 12, a non-porous layer formed on the porous layer; 13, an insulating layer such as an oxide film; and 14, a second substrate. The processes shown in Fig. 3 correspond to the manufacturing method shown in Fig. 1 (to be described later) (in Fig. 1, the first substrate is made by forming a porous layer at part of the substrate).

A semiconductor substrate according to a preferred embodiment of the present invention and a manufacturing method therefor will be described below.

### [First Embodiment]

A semiconductor substrate manufacturing method according to the first embodiment of the present invention will be described with reference to Figs. 1A to 1F.

First, as shown in Fig. 1A, a porous Si layer 2 is formed on the uppermost surface layer of an Si wafer (first substrate) 1.

Next, as shown in Fig. 1B, an epitaxial layer 3 is formed on the porous Si layer 2. The epitaxial layer can have either a single layer or a multi-layered structure with different impurities, concentrations, or materials.

As shown in Figs. 1C and 1D, the surface of a handle substrate (second substrate) 5 having a surface shape that satisfies a predetermined condition is bonded to the surface of the epitaxial layer 3 via an insulating layer 4, thereby forming a bonded substrate stack serving as an intermediate body. The insulating layer may be omitted. Alternatively, porous Si layers and epitaxial layers may be formed on both surfaces of an Si wafer serving as a first substrate, and two handle substrates may be bonded to both sides.

As shown in Fig. 1E, the Si wafer (first substrate) 1 except the porous Si layer 2 and epitaxial layer 3 is removed. The Si wafer 1 can be removed by grinding and polishing the Si wafer 1 or by separating the bonded substrate stack serving as an intermediate body into two substrates using the porous Si layer 2 as a separation layer. In the latter case, the bonded substrate stack as an intermediate body is divided into two substrates in the porous Si layer 2 or at the interface between the porous Si layer 2 and the first or second substrate by inserting a wedge, inserting a fluid jet, applying an ultrasonic wave, or applying an external force such as a tensile force to the porous Si layer 2, thereby separating the first and second substrates.

As shown in Fig. 1F, the porous Si layer 2 remaining on the surface of the handle substrate 5 is removed. The porous Si layer is removed by etching, polishing, or the like.

Finally, the surface of the epitaxial layer 3 is planarized. To planarize the surface, at least one of polishing, CMP, and hydrogen annealing is used.

### [Second Embodiment]

A semiconductor substrate manufacturing method according to the second embodiment of the present invention will be described with reference to Figs. 2A to 2F.

First, as shown in Fig. 2A, an insulating layer 4 such as an oxide film is formed on the uppermost surface layer of an Si wafer 1 serving as a first substrate. The insulating layer such as an oxide film may be omitted. The Si wafer 1 may be an epi-wafer. The epitaxial layer of the epi-wafer can have either a single layer or a multi-layered structure with different impurities, concentrations, or materials.

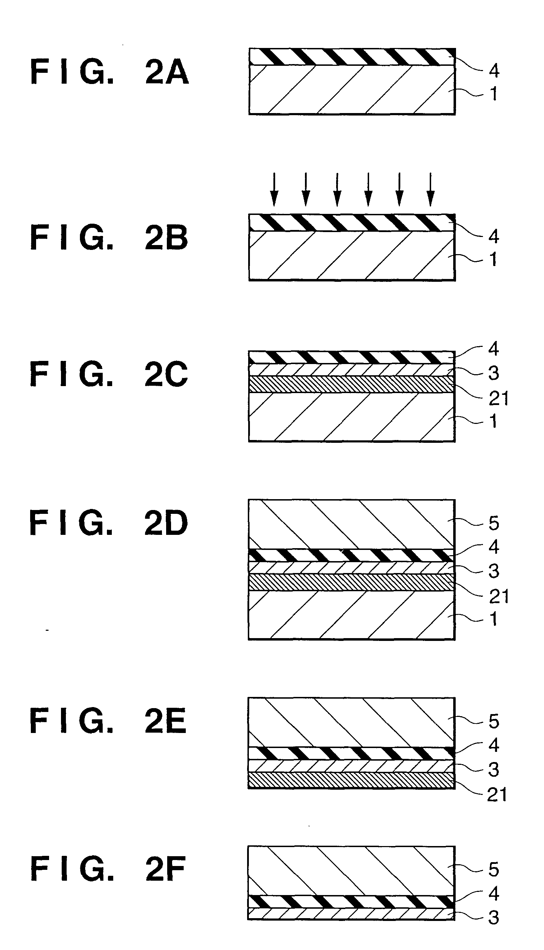

As shown in Fig. 2B, ions are implanted from the surface of the oxide film 4 to form an ion implantation layer 21 at a predetermined depth (Fig. 2C). The ion species to be implanted can be hydrogen ions, helium ions, or rare gas ions. Ions can be implanted by normal ion implantation of scan type or plasma full-plate implantation.

As shown in Fig. 2D, the surface of a handle substrate (second substrate) 5 having a surface shape that satisfies the above-described predetermined condition is bonded to the surface of the first substrate 1 via the insulating layer 4. The insulating layer may be omitted. Alternatively, ions may be implanted into both surfaces of the Si wafer serving as the first substrate, and two handle substrates may be bonded to both sides.

As shown in Fig. 2E, annealing is executed to separate the bonded substrate stack as an intermediate body into two substrates at the ion implantation layer 21, thereby removing the Si wafer 1 from the bonded substrate stack. Separation using the ion implantation layer may be executed by inserting a wedge, inserting a fluid jet, applying an ultrasonic wave, or applying an external force such as a tensile force to the ion implantation layer. Before separation, the bonded substrate stack may be annealed at a low temperature to increase the bonding strength. The Si wafer 1 may be removed not by separation but by grinding, polishing, or etching.

As shown in Fig. 2F, the residual ion implantation layer 21 remaining on the surface of the handle substrate 5 is removed.

Finally, the surface of the semiconductor layer 3 is planarized. To planarize the surface, at least one of polishing, CMP, and hydrogen annealing is used.

### [Third Embodiment]

In the above-described first and second embodiments, a porous layer or ion implantation layer is used. However, the present invention can also be used to manufacture a semiconductor substrate without using such a layer.

First, an insulating layer such as an oxide film is formed on the uppermost surface layer of an Si wafer serving as a first substrate. The insulating layer such as an oxide film may be omitted. The first Si wafer may be an epi-wafer. The epitaxial layer of the epi-wafer can have either a single layer or a multi-layered structure with different impurities, concentrations, or materials.

Next, the surface of a handle substrate (second substrate) having a surface shape that satisfies the above-described predetermined condition is bonded to the surface of the first substrate via the insulating layer, thereby forming a bonded substrate stack serving as an intermediate body.

The first wafer is removed from the bonded substrate stack as an intermediate body while leaving the active layer. The first Si wafer can be removed by grinding, polishing, or etching.

The surface of the active layer is planarized. To planarize the surface, at least one of polishing, CMP, and hydrogen annealing is used.

### [Fourth Embodiment]

A method of evaluating the surface shapes of semiconductor substrates manufactured by the above-described first to third embodiments will be described next as the fourth embodiment of the present invention.

In this embodiment, SOI wafers are manufactured by the semiconductor substrate manufacturing methods of the above-described first to third embodiments, and pseudo SOI wafers are manufactured following the same procedures as in the first to third embodiments except that no insulating layer is formed on an Si wafer serving as a first substrate. The nanotopographies on the surfaces of the resultant pseudo SOI wafers are measured as the nanotopographies of the SOI wafers manufactured by the first to third embodiments in which an insulating layer is formed on an Si wafer as a first substrate.

Examples of the present invention will be described next.

### (Example 1)

Twenty-five p- or n-type first single-crystal Si substrates having a resistivity of 0.01 to 0.02 Ω·cm were prepared.

The substrates were anodized in an HF solution. The anodizing conditions were as follows.
Current density: 7 (mA · cm⁻²)
Anodizing solution: HF : H₂O : C₂H₅OH = 1 : 1 : 1
Time: 11 (min)
Thickness of porous Si: 12 (µm)

The porous Si functions as an underlying layer for forming a high-quality epitaxial Si layer and as a separation layer. The porous Si layer does not function as a separation layer when the first substrate is to be removed from the bonded substrate stack as an intermediate body by grinding after bonding.

The anodizing solution only need contain HF, and ethanol is unnecessary. However, ethanol is effective in removing bubbles from the substrate surface. In place of ethanol, any other chemical having such a function, e.g., any other alcohol such as methyl alcohol or isopropyl alcohol or a surfactant can be used. Instead of adding the chemicals, bubbles may be eliminated from the surface by the vibration of an ultrasonic wave or the like.

The thickness of the porous Si layer is not limited to the above value, and a thickness from 0.1 to several hundred µm can be used.

These substrates were oxidized in an oxygen atmosphere at 400°C for 1 hr. With this oxidation, the inner walls of pores of the porous Si were covered with a thermal oxide film. Single-crystal Si was epitaxially grown on the porous Si to a thickness of 0.3 µm by CVD (Chemical Vapor Deposition). The growth conditions were as follows.
Source gas: SiH₂Cl₂/H₂
Gas flow rate: 0.5/180 l/min
Gas pressure: 80 Torr
Temperature: 950°C
Growth rate: 0.3 µm/min

Before actual epitaxial growth, the pores on the porous layer surface were buried by baking in a hydrogen atmosphere and/or supplying a trace amount of Si source in an epitaxial apparatus, thereby smoothening the surface. With this process, an epitaxial layer with a very low defect density (10⁴ cm⁻² or less) can be formed even on the porous Si.

A 200-nm thick SiO₂ layer was formed on the surface of the epitaxial Si layer by thermal oxidation. No SiO₂ layer was formed for one of the 25 substrates, which was to be used as a pseudo SOI wafer (for nanotopography measurement).

The surface of the SiO₂ layer (or the epitaxial surface of the pseudo SOI wafer) was made to face and brought into contact with the surface of an independently prepared second Si substrate. The resultant structure was annealed in a nitrogen atmosphere or an oxygen atmosphere at 1,100°C for 1 hr to increase the bonding strength.

As for the nanotopography of the second wafer, the surface shape satisfied the following conditions at all points in the wafer surface:
the maximum p-v (peak to valley) value in all 0.5 mm × 0.5 mm cells was 20 nm or less,
the maximum p-v value in all 2.0 mm × 2.0 mm cells was 50 nm or less,
the maximum p-v value in all 5.0 mm × 5.0 mm cells was 100 nm or less, and
the maximum p-v value in all 10 mm × 10 mm cells was 120 nm or less.

Pure water with a high pressure of 500 kgf/cm² was injected from the 0.15-mm nozzle of a wafer jet apparatus to the gap formed by the beveling between the two bonded wafers from a direction parallel to the bonding interface (surface) of the bonded wafer stack. At that time,
1) the nozzle was scanned in a direction in which the high-pressure pure water moved along the gap formed by the beveling,
2) the wafers were pinched by a wafer holder and rotated about their axes such that the high-pressure pure water was injected to the gap formed by the beveling along the entire perimeters of the wafers, or
3) both the above processes were employed, thereby separating the bonded substrate stack into two substrates through the porous Si layer across the wafer surface.

As a result, the SiO₂ layer, the epitaxial Si layer, and part of the porous Si layer, which were formed on the surface of the first substrate, were transferred to the second substrate side. Only porous Si remained on the surface of the first substrate.

The separation may be executed not by using a wafer jet but by inserting a gas jet, inserting a solid wedge, applying a tensile force, applying a shearing force, applying an ultrasonic wave, or applying a static pressure (a gas or liquid) to the gap formed by the beveling.

Instead of separation, the entire surface of the porous Si may be exposed by grinding, polishing, or etching from the back surface side of the first substrate of the two bonded wafers. In this case,
a) the structure is ground to the porous Si at a stroke,
b) the structure is ground to a point immediately before the porous Si, and the remaining bulk Si is removed by RIE (dry etching) or wet etching, or
c) the structure is ground to a point immediately before the porous Si, and the remaining bulk Si is removed by polishing, thereby exposing the entire surface of the porous Si layer.

After that, the porous Si layer transferred onto the second substrate was selectively etched in a solution mixture containing 49% hydrofluoric acid, 30% hydrogen peroxide, and water under stirring. Since single-crystal Si was not etched, the porous Si was completely removed by selective etching using the single-crystal Si as an etch-stop material. In this selective etching, when a rotating wafer is etched by turning on/off an ultrasonic wave using an apparatus with a circulation unit, the wafer is etched while suppressing the etching distribution within the wafer and between wafer.

The etch rate of the non-porous single-crystal Si by the above etchant is very low. The selectivity ratio of the etch rate of the porous layer to that of the non-porous single-crystal Si is as high as 10⁵ or more. For this reason, the etching amount (about several ten Å) as a decrease in film thickness of the non-porous layer is negligible in practical use.

That is, 24 single-crystal Si layers (SOI wafers) with a thickness of 0.2 µm were formed on Si oxide films. In addition, a pseudo SOI wafer (wafer for surface nanotopography measurement) having an epitaxial Si layer formed on an Si substrate without intervening any oxide film was formed. The single-crystal Si layer remained unchanged even when the porous Si was selectively etched. When the film thickness of each single-crystal Si layer formed was measured at 100 points on the entire surface, the film thickness uniformity was 201 nm ± 4 nm.

Observation of the cross section with a transmission electron microscope revealed that no new crystal defects were introduced in the Si layer, and satisfactory crystallinity was maintained.

In addition, annealing was executed in hydrogen at 1,100°C for 1 hr, and the surface roughness was evaluated with an atomic force microscope. The root-mean-square of the roughness in a 50-µm square area was about 0.2 nm, i.e., equivalent to that of a commercially available normal Si wafer.

Surface planarization by annealing in hydrogen is done with little decrease in Si layer thickness. For this reason, when the nanotopography of the pseudo SOI wafer (wafer for surface nanotopography measurement) was measured, the measurement results were almost the same as those of the original second handle wafer. That is, the surface shape satisfied the following conditions at all points in the wafer surface:
the maximum p-v value in all 0.5 mm × 0.5 mm cells was 20 nm or less,
the maximum p-v value in all 2.0 mm × 2.0 mm cells was 50 nm or less,
the maximum p-v value in all 5.0 mm × 5.0 mm cells was 100 nm or less, and
the maximum p-v value in all 10 mm × 10 mm cells was 120 nm or less.

When an SOI wafer was manufactured using a second handle wafer that satisfied only two of the above four conditions, the nanotopography of the SOI wafer also satisfied only two conditions. More specifically, when a wafer that satisfied two of four conditions:
the maximum p-v value in all 0.5 mm × 0.5 mm cells was 15 nm,
the maximum p-v value in all 2.0 mm × 2.0 mm cells was 51 nm,
the maximum p-v value in all 5.0 mm × 5.0 mm cells was 90 nm, and
the maximum p-v value in all 10 mm × 10 mm cells was 125 nm was used as a second wafer (handle wafer), the manufactured wafer satisfied, in correspondence with the second wafer, two of four conditions:
the maximum p-v value in all 0.5 mm × 0.5 mm cells was 16 nm,
the maximum p-v value in all 2.0 mm × 2.0 mm cells was 52 nm,
the maximum p-v value in all 5.0 mm × 5.0 mm cells was 85 nm, and
the maximum p-v value in all 10 mm × 10 mm cells was 124 nm.

Surface planarization by hydrogen annealing is most preferable in the present invention. However, surface planarization may be executed not by hydrogen annealing by polishing such as CMP. In this case, note that the nanotopography depends on the CMP capability, and the CMP may degrade the film thickness distribution. That is, even if a surface is completely planarized by CMP, the film thickness distribution may degrade unless the nanotopography of the original second substrate is good, as shown in Fig. 7A. Conversely, if the nanotopography is good, slight degradation by CMP can be allowed. In CMP, planarization must be promoted by making the chemical components as large as possible.

When the nanotopography measurement result of a pseudo SOI wafer (wafer for surface nanotopography measurement) whose surface was smoothened by hydrogen annealing and the nanotopography measurement result of the original second substrate were compared, the two results had little difference. It can therefore be supposed that the nanotopography of each of the remaining 24 SOI substrates whose surfaces were smoothened by hydrogen annealing is almost equal to the nanotopography of the original second substrate. For a pseudo SOI wafer (wafer for surface nanotopography measurement) having a surface planarized by CMP, the nanotopography measurement result exhibited degradation of several %. Hence, the nanotopography of each SOI was determined as lower by about 5% with a margin than the nanotopography of the original second substrate.

Even when an oxide film was formed not on the epitaxial layer surface but on the second substrate surface, or on both surfaces, the same result as described above was obtained.

The porous Si layer remaining on the first substrate side was also selectively etched in a solution mixture containing 49% hydrofluoric acid, 30% hydrogen peroxide, and water under stirring. After that, a surface treatment such as hydrogen annealing or surface polishing was executed so that the substrate could be used again as the first or second substrate. Alternatively, the substrate was reproduced by a normal wafer reproduction method and used as again the first or second substrate.

To use the substrate as the second substrate, its surface shape must satisfy at least one of the following conditions at all points in the wafer surface:
the maximum p-v value in all 0.5 mm × 0.5 mm cells was 20 nm or less,
the maximum p-v value in all 2.0 mm × 2.0 mm cells was 50 nm or less,
the maximum p-v value in all 5.0 mm × 5.0 mm cells was 100 nm or less, and
the maximum p-v value in all 10 mm × 10 mm cells was 120 nm or less.

More specifically, when a handle substrate that satisfied conditions:
the maximum p-v value in all 0.5 mm × 0.5 mm cells was 25 nm,
the maximum p-v value in all 2.0 mm × 2.0 mm cells was 43 nm,
the maximum p-v value in all 5.0 mm × 5.0 mm cells was 100 nm, and
the maximum p-v value in all 10 mm × 10 mm cells was 145 nm or less was used,
a bonded substrate stack that satisfied conditions:
the maximum p-v value in all 0.5 mm × 0.5 mm cells was 23 nm,
the maximum p-v value in all 2.0 mm × 2.0 mm cells was 40 nm,
the maximum p-v value in all 5.0 mm × 5.0 mm cells was 108 nm, and
the maximum p-v value in all 10 mm × 10 mm cells was 143 nm or less was obtained.

If the difference in optical constant such as refractive index between the multiple layers on the surface is large, the nanotopography of the wafer itself can hardly be measured. This is because the current nanotopography measuring method is an optical method. In Example 1, a structure contains Si, SiO₂, and Si sequentially from the surface. That is, the number of light reflecting surfaces is three, including the uppermost surface. For this reason, which surface has the nanotopography represented by the nanotopography measurement value is unknown. Hence, as described above, the nanotopography of a pseudo SOI wafer formed following the same bonding procedures except that no oxide film is formed is represented. When the reproducibility of each process is high, the measurement by this measuring method is sufficiently meaningful.

A plurality of bonded wafer stacks may be separated at once by arraying them in the plane direction and scanning the water jet nozzle once.

Alternatively, a plurality of bonded wafer stacks may be automatically separated by arraying them in a direction perpendicular to the planes, X-Y scanning the water jet nozzle, and sequentially injecting a water jet to the plurality of bonded wafer stacks.

Nanotopography was measured by WIS-CR83-SQM or NanoMapper available from ADE, Surfscan-SP1-STN available from KLA-Tencor, DynaSearch available from New Creation, or NanoMetro available from KURODA PRECISION INDUSTRIES.

In Example 1, the same result as described above was obtained even by regulating not nanotopography but site flatness such as an SFQR. More specifically, when a second substrate whose SFQR satisfied
0.25 µm/25 mm × 25 mm/94% or more
was used, the SFQR of the manufactured semiconductor substrate also satisfied
0.25 µm/25 mm × 25 mm/94% or more
The site flatness was measured using Ultra Gauge available from ADE. This measuring apparatus employs a capacitance scheme. For this reason, for a thin film (thickness of second substrate >> thickness of thin film), even if it has a multi-layered structure, the measurement value can be directly obtained because the surface information of a semiconductor substrate manufactured in the present invention can be obtained.

In Example 1, if substrates are bonded without sandwiching an oxide film between them, a multi-layered structure of layers having different impurity concentrations is formed. This structure can also be used as a pn junction or buried epitaxial layer.

When an epitaxial layer formed from a heterogeneous material such as SiGe, GaAs, SiC, or C is bonded, a heteroepitaxial layer on an Si substrate can be formed. In this case, the epitaxial layer may be bonded via an oxide film.

The second substrate can also be formed from any other material as long as it satisfies the surface shape conditions. For example, silica, sapphire, ceramic, carbon, or SiC can be used.

To measure the surface nanotopography of a transparent substrate, the surface nanotopography must be measured in advance by coating the surface with a material having little light transmittance by vacuum deposition or the like.

### (Example 2)

SOI substrates were manufactured following the same procedures as in Example 1 except a porous Si layer had a two-layered structure.

The substrates were anodized in an HF solution. The anodizing conditions were as follows.
Current density: 8 (mA·cm⁻²)
Anodizing solution: HF : H₂O : C₂H₅OH = 1 : 1 : 1
Time: 11 (min)
Thickness of porous Si: 13 (µm)
and
Current density: 22 (mA·cm⁻²)
Anodizing solution: HF : H₂O : C₂H₅OH = 1 : 1 : 1
Time: 2 (min)
Thickness of porous Si: 3 (µm)
or
Current density: 8 (mA · cm⁻²)
Anodizing solution: HF : H₂O : C₂H₅OH = 1 : 1 : 1
Time: 5 (min)
Thickness of porous Si: 8 (µm)
and
Current density: 33 (mA · cm⁻²)
Anodizing solution: HF : H₂O : C₂H₅OH = 1 : 1 : 1
Time: 1.3 (min)
Thickness of porous Si: 3 (µm)

The first porous Si is used to form a high-quality epitaxial Si layer, and the second porous Si is also used as a separation layer. If the first substrate is removed by grinding, the second porous Si layer is not used as a separation layer.

The separation surface was limited near the interface between the first and the second layers. This was effective in planarizing the separation surface.

### (Example 3)

Twenty-five p- or n-type first single-crystal Si substrates having a resistivity of 10 to 20 Ω·cm were prepared.

A 200-nm thick SiO₂ layer was formed on each surface. A 300- to 400-nm thick epitaxial layer may be formed before the oxidation. The layer may be thicker. One of the 25 substrates had no SiO₂ because it was used as a pseudo SOI wafer (for surface nanotopography measurement).

Ions were implanted from the first substrate surface such that the projection range was set in the Si substrate. With this process, a layer serving as a separation layer was formed at a depth corresponding to the projection range (as a microcavity layer or a strained layer by a heavily ion-species-implanted layer).

For example, H⁺ was implanted at 40 keV and 5 × 10¹⁶ cm⁻². The projection range is about 460 to 470 nm.

Ions may be implanted at once using not a normal ion implantation apparatus but a plasma apparatus. In this case, H²⁺ may more efficiently be implanted by changing the plasma generation conditions.

The surface of the SiO₂ layer (or the epitaxial surface of the pseudo SOI wafer) was made to face and brought into contact with the surface of an independently prepared second Si substrate. The resultant structure was annealed at 300°C for 10 hrs to bond the substrates. The bonding strength could be increased by a pre-process such as an N₂ or O₂ plasma process before the substrates were made to face each other. Annealing may be omitted here.

As for the nanotopography of the second wafer, the surface shape satisfied the following conditions at all points in the wafer surface:
the maximum p-v value in all 0.5 mm × 0.5 mm cells was 20 nm or less,
the maximum p-v value in all 2.0 mm × 2.0 mm cells was 50 nm or less,
the maximum p-v value in all 5.0 mm × 5.0 mm cells was 100 nm or less, and
the maximum p-v value in all 10 mm × 10 mm cells was 120 nm or less.

When annealing was executed at 400°C for 10 hrs, the wafer was divided into two substrates at the ion implantation layer across the wafer surface.

As a result, the SiO₂ layer, the epitaxial Si layer, and part of the ion implantation layer, which were formed on the surface of the first substrate, were transferred to the second substrate side. Only the ion implantation layer remained on the surface of the first substrate.

The separation may be executed not by annealing but by inserting a fluid (a gas or liquid) jet, inserting a solid wedge, applying a tensile force, applying a shearing force, applying an ultrasonic wave, or applying a static pressure (a gas or liquid) to the gap formed by the beveling.

Instead of separation, the entire surface of the ion implantation layer may be exposed by grinding, polishing, or etching from the lower surface side of the first substrate of the two bonded wafers.

After that, the ion implantation layer transferred onto the second substrate was removed using a polishing apparatus such as CMP or etching, and surface planarization was also performed. After that, hydrogen annealing may be executed. Alternatively, hydrogen annealing may be executed without removing the ion implantation layer.

That is, 24 single-crystal Si layers with a thickness of 0.2 µm were formed on Si oxide films. In addition, a pseudo SOI wafer (wafer for surface nanotopography measurement) having an epitaxial Si layer formed on an Si substrate without intervening any oxide film was formed. When the film thickness of each single-crystal Si layer formed was measured at 100 points on the entire surface, the film thickness uniformity was 201 nm ± 5 nm.

Observation of the section with a transmission electron microscope revealed that no new crystal defects were introduced in the Si layer, and satisfactory crystallinity was maintained.

In addition, the surface roughness was evaluated with an atomic force microscope. The root-mean-square of the roughness in a 50-µm square area was about 0.2 nm, i.e., equivalent to that of a commercially available normal Si wafer.

This CMP surface planarization is done while decreasing the Si layer thickness. For this reason, the nanotopography of a resultant SOI wafer is affected not only by the nanotopography of the original second handle wafer but also by the polishing characteristic of the CMP itself. In this case, the smoothening was performed by making the chemical components as large as possible. The nanotopography of the pseudo SOI wafer (wafer for surface nanotopography measurement) was measured. The nanotopography was almost the same as that of the original second handle wafer, i.e., the surface shape satisfied the following conditions at all points in the wafer surface:
the maximum p-v value in all 0.5 mm × 0.5 mm cells was 20 nm or less,
the maximum p-v value in all 2.0 mm × 2.0 mm cells was 50 nm or less,
the maximum p-v value in all 5.0 mm × 5.0 mm cells was 100 nm or less, and
the maximum p-v value in all 10 mm × 10 mm cells was 120 nm or less.

Even when a second handle wafer that satisfied only two of the above four conditions was used, the nanotopography of a resultant wafer satisfied all the four conditions. However, the nanotopography depends on the CMP capability, and the CMP may degrade the film thickness distribution. That is, even if a surface is completely planarized by CMP, the film thickness distribution may degrade unless the nanotopography of the original second substrate is good, as shown in Fig. 7A. Conversely, if the nanotopography is good, slight degradation by CMP can be allowed.

Smoothening may be performed not by CMP but by hydrogen annealing. Since surface planarization by annealing in hydrogen was executed with little decrease in Si layer thickness, the nanotopography of a resultant SOI wafer was almost equal to that of the original second handle wafer. Preferably, smoothening by hydrogen annealing is performed.

When the nanotopography measurement result of a pseudo SOI wafer (wafer for surface nanotopography measurement) was compared with the nanotopography measurement result of the original second substrate, the two results had little difference in hydrogen annealing. It was therefore regarded that the nanotopography of each of the remaining 24 SOI substrates was almost equal to the nanotopography of the original second substrate. In CMP, the nanotopography exhibited degradation of several %. Hence, the nanotopography of each resultant SOI was determined as lower by about 5% with a margin than the nanotopography of the original second substrate.

Even when an oxide film was formed not on the epitaxial layer surface but on the second substrate surface, or on both surfaces, the same result as described above was obtained.

When the ion implantation layer remaining on the first substrate side was then reproduced by a normal wafer reproduction method, the substrate could be used again the first or second substrate.

To use the substrate as the second substrate, its surface shape must satisfy at least one of the following conditions at all points in the wafer surface:
the maximum p-v value in all 0.5 mm × 0.5 mm cells was 20 nm or less,
the maximum p-v value in all 2.0 mm × 2.0 mm cells was 50 nm or less,
the maximum p-v value in all 5.0 mm × 5.0 mm cells was 100 nm or less, and
the maximum p-v value in all 10 mm × 10 mm cells was 120 nm or less.

If the difference in optical constant such as refractive index between the multiple layers on the surface is large, the nanotopography of the wafer itself can hardly be measured. This is because the current nanotopography measuring method is an optical method. In Example 3, a structure contains Si, SiO₂, and Si sequentially from the surface. That is, the number of light reflecting surfaces is three, including the uppermost surface. For this reason, which surface has the nanotopography represented by the nanotopography measurement value is unknown. Hence, in Example 3, as described above, the nanotopography of an SOI wafer formed following the same bonding procedures except that no oxide film is formed is represented. When the reproducibility of each process is high, the measurement by this measuring method is sufficiently meaningful.

Nanotopography was measured by WIS-CR83-SQM or NanoMapper available from ADE, Surfscan-SP1-STN available from KLA-Tencor, DynaSearch available from New Creation, or NanoMetro available from KURODA PRECISION INDUSTRIES.

In Example 3, the same result as described above was obtained even by regulating not nanotopography but site flatness such as an SFQR. More specifically, when a second substrate whose SFQR satisfied
0.25 µm/25 mm × 25 mm/94% or more
was used, the SFQR of the manufactured semiconductor substrate also satisfied
0.25 µm/25 mm × 25 mm/94% or more
The site flatness was measured using Ultra Gauge available from ADE. This measuring apparatus employs a capacitance scheme. For this reason, for a thin film (thickness of second substrate >> thickness of thin film), even if it has a multi-layered structure, the measurement value can be directly obtained because the surface information of a semiconductor substrate manufactured in the present invention can be obtained.

In Example 3, if substrates are bonded without sandwiching an oxide film between them, a multi-layered structure of layers having different impurity concentrations is formed. This structure can also be used as a pn junction or buried epitaxial layer.

When an epitaxial layer formed from a heterogeneous material such as SiGe, GaAs, SiC, or C is bonded, a heteroepitaxial layer on an Si substrate can be formed. In this case, the epitaxial layer may be bonded via an oxide film.

When SiGe, GaAs, SiC, or C is used as the first substrate, a heteroepitaxial layer on the Si substrate can be formed without forming an epitaxial layer first. In this case, the substrates may be bonded via an oxide film.

The second substrate can also be formed from any other material as long as it satisfies the surface shape conditions. For example, silica, sapphire, ceramic, carbon, or SiC can be used.

To measure the surface nanotopography of a transparent substrate, the surface nanotopography must be measured in advance by coating the surface with a material having little light transmittance by vacuum deposition or the like.

### (Example 4)

The surface shape of an original second substrate is measured in advance. The measurement is done on the basis of a standard to be adapted to a resultant semiconductor substrate.

Only substrates that satisfied the standard to be adapted to a resultant semiconductor substrate were used as second substrates.

Semiconductor substrates were manufactured following the same procedures as in Examples 1 to 3. The manufactured substrates were checked by sampling inspection or one hundred percent inspection and delivered with inspection cards.

Once the correlation in surface nanotopography before and after the manufacturing is defined by Examples 1 to 3, no pseudo semiconductor substrate need be formed. When the nanotopography of the original second substrate is measured in advance, the measurement value can be used as original data of the nanotopography of a resultant semiconductor wafer. The nanotopography of a resultant semiconductor wafer is determined by the correlation for each process in Examples 1 to 3.

In the above-described examples, epitaxial growth on porous Si can be executed not only by CVD but also by various methods such as MBE, sputtering, and liquid phase growth. The selective etchant for the porous layer or ion implantation layer is not limited to a solution mixture of 49% hydrofluoric acid, 30% hydrogen peroxide, and water. An ion implantation layer can be selectively etched even by a solution mixture of hydrofluoric acid, nitric acid, and acetic acid because of its large surface area.

The remaining processes can also be executed not only under conditions limited to these examples but under various conditions.

As has been described above, according to the present invention, a semiconductor substrate and method of manufacturing the same, and a bonded substrate stack surface shape measuring method, which can solve the above-described problem and meet the above-described requirement, can be provided.

That is, according to the present invention, a semiconductor substrate having a managed surface shape can be manufactured by managing the surface shape of a handle substrate (second substrate).

In addition, according to the present invention, nanotopography on a substrate surface, which is difficult to express as a numerical value, can be quantitatively expressed.

As many apparently widely different embodiments of the present invention can be made without departing from the spirit and scope thereof, it is to be understood that the invention is not limited to the specific embodiments thereof except as defined in the claims.

## Claims

1. A method of manufacturing a semiconductor substrate by bonding a device substrate to a handle substrate,
wherein a surface shape of the handle substrate on a bonding side is almost equal to that of a resultant semiconductor substrate.

2. The method according to claim 1, wherein the surface shape of the handle substrate is defined by at least one of an SFQR, SFQD, and nanotopography.

3. A method of manufacturing a semiconductor substrate by bonding a device substrate to a handle substrate,
wherein a surface shape on a bonding-side surface of the handle substrate is represented by
SFQR; 0.30 µm/25 mm × 25 mm/85% or more, and
a surface shape of the semiconductor substrate manufactured using the handle substrate satisfies
SFQR; 0.30 µm/25 mm × 25 mm/85% or more.

4. A method of manufacturing a semiconductor substrate by bonding a device substrate to a handle substrate,
wherein a surface shape of the handle substrate on a bonding side satisfies at least one of conditions:
a maximum p-v value in all 0.5 mm × 0.5 mm cells is not more than 20 nm,
the maximum p-v value in all 2.0 mm × 2.0 mm cells is not more than 50 nm,
the maximum p-v value in all 5.0 mm × 5.0 mm cells is not more than 100 nm, and
the maximum p-v value in all 10 mm × 10 mm cells is not more than 120 nm, and
a surface shape of the semiconductor substrate manufactured using the handle substrate satisfies the same conditions as those satisfied by the handle substrate of conditions:
the maximum p-v value in all 0.5 mm × 0.5 mm cells is not more than 20 nm,
the maximum p-v value in all 2.0 mm × 2.0 mm cells is not more than 50 nm,
the maximum p-v value in all 5.0 mm × 5.0 mm cells is not more than 100 nm, and
the maximum p-v value in all 10 mm × 10 mm cells is not more than 120 nm.

5. A method of manufacturing a semiconductor substrate by bonding a device substrate to a handle substrate,
wherein a surface shape of the handle substrate on a bonding side satisfies at least one of conditions:
a maximum p-v value in all 0.5 mm × 0.5 mm cells is not more than 20 nm,
the maximum p-v value in all 2.0 mm × 2.0 mm cells is not more than 50 nm,
the maximum p-v value in all 5.0 mm × 5.0 mm cells is not more than 100 nm, and
the maximum p-v value in all 10 mm × 10 mm cells is not more than 120 nm.

6. The method according to any one of claims 1 to 5, further comprising the steps of:
(a) preparing, as the device substrate, a first substrate having at least an active layer, a porous layer, and a substrate sequentially from the surface;
(b) preparing a second substrate as the handle substrate;
(c) bonding a major surface of the first substrate and a major surface of the second substrate;
(d) removing a substrate portion on the first substrate side from a bonded substrate stack to expose the porous layer; and
(e) removing the porous layer remaining on the second substrate.

7. The method according to any one of claims 1 to 5, further comprising the steps of:
(a) preparing, as the device substrate, a first substrate having an ion implantation layer with a projecting range at a predetermined depth from a major surface;
(b) preparing a second substrate as the handle substrate;
(c) bonding the major surface of the first substrate and a major surface of the second substrate;
(d) removing a portion outside the ion implantation layer on the first substrate side from a bonded substrate stack to expose the ion implantation layer; and
(e) removing the ion implantation layer remaining on the second substrate.

8. The method according to claim 4 or 5, wherein a semiconductor wafer that satisfies at least two of the four conditions of the handle substrate is used as the handle substrate.

9. The method according to claim 4 or 5, wherein a semiconductor wafer that satisfies all the four conditions of the handle substrate is used as the handle substrate.

10. The method according to any one of claims 1 to 5, wherein a root-mean-square value of a surface roughness on the bonding side of the handle substrate is not more than 1 nm in an about 1 mm × 1 mm area.

11. A semiconductor substrate manufactured by the method of any one of claims 1 to 5.

12. A surface shape measuring method for a bonded substrate stack manufactured by bonding a first substrate and a second substrate via a layer formed from a heterogeneous material different from the first substrate or second substrate,
wherein a pseudo bonded substrate stack is manufactured by bonding a first substrate and a second substrate without sandwiching the layer of the heterogeneous material,
a surface shape of the pseudo bonded substrate stack is measured, and
a measurement value is regarded as a surface shape of the bonded substrate stack.
